# EUROPÄISCHE PATENTSCHRIFT

(11) **EP 0 432 574 B1**
(45) Veröffentlichungstag und Bekanntmachung des Hinweises auf die Patenterteilung: **18.09.1996**
(21) Anmeldenummer: 90122718.1
(22) Anmeldetag: 28.11.1990
(51) Int. Cl.: C07F 5/00, C07F 5/06, C23C 16/30

(54) **Heterocyclische metallorganische Verbindungen**
Heterocyclic organometal compounds
Composés organométalliques hétérocycliques

(30) Priorität: 12.12.1989 DE 3941005; 23.03.1990 DE 4009394
(43) Veröffentlichungstag der Anmeldung: 19.06.1991
(73) Patentinhaber: MERCK PATENT GmbH, D-64271 Darmstadt (DE)
(72) Erfinder: Pohl, Ludwig, Dr., W-6100 Darmstadt (DE); Hostalek, Martin, Dr., W-6100 Darmstadt (DE); Lokai, Martin, W-6100 Darmstadt (DE)

(56) Entgegenhaltungen:
- EP-A- 0 324 444
- WO-A-89/01479
- INORGANIC CHEMISTRY, Band 15, Nr. 9, September 1976, Seiten 2110-2115; O.T. BEACHLEY, Jr. et al.
- JOURNAL OF ORGANOMETALLIC CHEMISTRY, Band 325, Nr. 1/2, 12. Mai 1987, Seiten 55-67; D.C. BRADLEY et al.
- Chemical Abstracts 59:642g-6425f

## Beschreibung

Die Erfindung betrifft heterocyclische metallorganische Verbindungen, die Aluminium, Gallium oder Indium als Metalle enthalten, sowie deren Verwendung für die Herstellung dünner Filme oder epitaktischer Schichten durch Gasphasenabscheidung.

Die Abscheidung solcher Schichten aus entweder reinen Elementen der dritten Gruppe oder aus Kombinationen mit anderen Elementen, wie z.B. Galliumarsenid, Indiumphosphid oder Galliumphosphid, kann zur Herstellung von elektrischen, dielektrischen, elektronischen, optischen und optoelektronischen Bau- und Schaltelementen, Verbindungshalbleitern und Lasern verwendet werden. Die Abscheidung dieser Schichten erfolgt aus der Gasphase.

Die Eigenschaften dieser Filme hängen von den Abscheidungsbedingungen und der chemischen Zusammensetzung des abgeschiedenen Films ab.

Für die Abscheidung aus der Gasphase kommen alle bekannten Methoden wie die Metal-Organic Chemical Vapour Deposition (MOCVD) Methode, die Metal-Organic Molecular Beam Epitaxy (MOMBE) die Photo-Metal-Organic Vapour Phase (Photo-MOVP) Methode, bei welcher die Substanzen durch UV-Bestrahlung zersetzt werden, die Laser-Chemical Vapour Deposition (Laser CVD) Methode oder die Metal-Organic Magnetron Sputtering (MOMS) Methode in Frage. Die Vorteile gegenüber anderen Methoden sind ein kontrollierbares Schichtenwachstum, eine genaue Dotierungskontrolle sowie eine aufgrund der Normal- oder Niederdruckbedingungen einfache Handhabung und Produktionsfreundlichkeit.

Bei der MOCVD-Methode werden metallorganische Verbindungen eingesetzt, die sich unter Abscheidung des Metalls bei einer Temperatur unterhalb 1100 °C zersetzen. Typische Apparaturen, die zur Zeit für MOCVD benutzt werden, bestehen aus einem "bubbler" mit einer Zufuhr für die metallorganische Komponente, einer Reaktionskammer, die das zu beschichtende Substrat enthält, sowie einer Quelle für ein Trägergas, das gegen die metallorganische Komponente inert sein soll. Der "bubbler" wird auf einer konstanten, relativ niedrigen Temperatur gehalten, die vorzugsweise über dem Schmelzpunkt der metallorganischen Verbindung, aber weit unterhalb der Zersetzungstemperatur liegt. Die Reaktions- oder Zersetzungskammer hat vorzugsweise eine sehr viel höhere Temperatur, die unterhalb 1100 °C liegt, bei welcher die metallorganische Verbindung sich vollständig zersetzt und das Metall abgeschieden wird. Durch das Trägergas wird die metallorganische Verbindung in den Dampfzustand gebracht und mit dem Trägergas in die Zersetzungskammer geschleust. Der Massenfluß des Dampfes ist gut zu kontrollieren, und somit ist auch ein kontrolliertes Wachsen der dünnen Schichten möglich.

Bislang wurden für die Gasphasenabscheidung hauptsächlich Metallalkyle wie z.B. Trimethylgallium, Trimethylaluminium oder Trimethylindium verwendet. Diese Verbindungen sind jedoch extrem luftempfindlich, selbstentzündlich und teilweise bereits bei Raumtemperatur zersetzlich. Daher sind für die Herstellung, den Transport, die Lagerung und die Anwendung dieser Verbindungen aufwendige Vorsichtsmaßnahmen notwendig. Es sind auch einige etwas stabilere Addukte der Metallalkyle mit Lewisbasen wie z.B. Trimethylamin und Triphenylphosphin bekannt (z.B. beschrieben in GB 21 23 422, EP-A 108 469 oder EP-A 176 537), die jedoch aufgrund des geringen Dampfdruckes nur bedingt für die Gasphasenabscheidung geeignet sind.

Aus der DE-OS 36 31 469 sind metallorganische Verbindungen, die für die MOCVD-Technik geeignet sind, bekannt. Die dort beschriebenen Verbindungen enthalten jedoch keine Verbindungen, in denen das Element der III. und der V. Gruppe des Periodensystems, also das Akzeptor- und das Donoratom, kovalent gebunden sind.

Aufgabe der vorliegenden Erfindung war es nun, metallorganische Verbindungen zu finden, die einfach handhabbar und bei Raumtemperatur stabil sind, und die einen genügend hohen Dampfdruck aufweisen, um sich aus der Gasphase zersetzen zu lassen, also für die verschiedenen Methoden der Gasphasenabscheidung geeignet sind.

Es wurde nun gefunden, daß sich metallorganische Verbindungen, die das Akzeptoratom der III. Gruppe und zwei Donoratome der V. Gruppe in einer cyclischen Anordnung aufweisen, wobei entweder eines der Donoratome kovalent und das andere über eine Donor-Akzeptor-Wechselwirkung an das Akzeptoratom gebunden ist oder beide Donoratome kovalent am Akzeptoratom gebunden vorliegen, hervorragend für die Gasphasenabscheidung eignen.

Diese heterocyclischen metallorganischen Verbindungen haben den entscheidenden Vorteil gegenüber den bisher verwendeten und bekannten metallorganischen Verbindungen, daß eine zusätzliche intramolekulare Stabilisierung durch Elektronenübertragung von den Donoratomen auf das elektronenarme Akzeptoratom erfolgt. Die Anwesenheit von mindestens zwei Donoratomen erhöht dabei die Stabilität.

Überraschenderweise haben die erfindungsgemäßen Verbindungen trotz dieser erhöhten Stabilität genügend hohe Dampfdrucke, um sich aus der Gasphase zersetzen zu lassen.

Gegenstand der Erfindung ist daher die Verwendung von heterocyclischen metallorganischen Verbindungen der Formel I 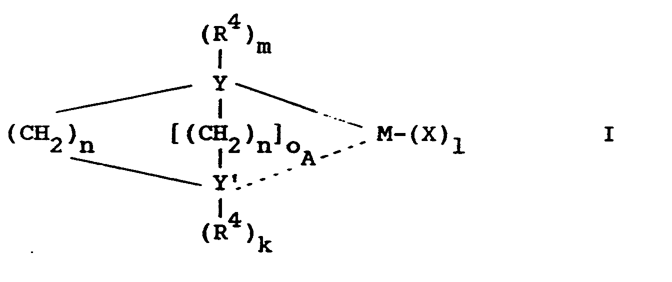 worin
- M: Aluminium, Gallium oder Indium,
- Y, Y': jeweils Stickstoff, Phosphor oder Arsen,
- n: jeweils 2, 3 oder 4,
- m: 0 oder 1,
- o: 0 oder 1,
- m + o: 1,
- l: 1 oder 2,
- A: falls l = 1 eine kovalente Bindung zwischen Y' und M, oder falls l = 2 eine Donor-Akzeptor-Wechselwirkung zwischen Y' und M,
- k: 0, 1 oder 2 mit den Maßgaben, daß
im Falle l = 1 und 0 = 1 k = 0,
im Falle l = 2 und 0 = 1 k = 1,
im Falle l = 1 und 0 = 0 k = 1 und
im Falle l = 2 und 0 = 0 k = 2,
- X: R³,
-(CHR⁵)ₚ-Z mit p = 1, 2, 3, 4 oder 5,
im Falle von Z = F oder Perfluoralkyl kann p auch O sein,
o-(CH₂)ᵣ-C₆H₄-(CH₂)ₛ-Z,
1,2-(CH₂)ᵣ-C₆H₁₀-(CH₂)ₛ-Z,
1,2-(CH₂)ᵣ-C₆H₈-(CH₂)ₛ-Z,
1,2-(CH₂)ᵣ-C₆H₆-(CH₂)ₛ-Z,
1,2-(CH₂)ᵣ-C₅H₈-(CH₂)ₛ-Z,
1,2-(CH₂)ᵣ-C₅H₆-(CH₂)ₛ-Z,
1,2-(CH₂)ᵣ-C₅H₄-(CH₂)ₛ-Z oder
1,2-(CH₂)ᵣ-C₄H₆-(CH₂)ₛ-Z,
- Z: -NR¹R², -PR¹R², -AsR¹R², -F oder Perfluoralkyl mit bis zu 7 C-Atomen,
- r und s: jeweils unabhängig voneinander 0, 1, 2 oder 3,
- R¹, R², R³ und R⁴: jeweils unabhängig voneinander H, eine Alkyl- oder Alkenylgruppe mit bis zu 8 C-Atomen, wobei diese Gruppen teilweise oder vollständig fluoriert sein können, eine Cycloalkyl- oder Cycloalkenylgruppe mit 3-8 C-Atomen oder eine Arylgruppe,
und
- R⁵: jeweils H oder eine Alkylgruppe mit bis zu 4 C-Atomen, die auch teilweise oder vollständig fluoriert sein kann,
bedeutet, als Ausgangsprodukte für die Herstellung dünner Filme oder epitaktischer Schichten durch Gasphasenabscheidung sowie ein Verfahren zur Herstellung dünner Filme oder epitaktischer Schichten durch Gasphasenabscheidung aus metallorganischen Verbindungen, bei dem als metallorganische Verbindungen die Verbindungen der Formel I eingesetzt werden. Ferner ist Gegenstand der Erfindung, daß man bei dem erfindungsgemäßen Verfahren während des Abscheidungsprozesses eine oder mehrere unter den angewandten Reaktionsbedingungen gasförmige Verbindungen des Arsens, Antimons oder Phosphors zuführt. Schließlich sind Gegenstand der Erfindung neue Verbindungen der Formel I, in der M Gallium oder Indium bedeutet.

Die erfindungsgemäßen Verbindungen weisen aufgrund ihrer mindestens zweifachen intramolekularen Stabilisierung eine hohe Beständigkeit gegenüber Luft und Sauerstoff auf. Sie sind nicht selbstentzündlich und damit einfach zu handhaben.

In der Gasphase jedoch lassen sich die erfindungsgemäßen Verbindungen leicht unter Abscheidung des Metalls zersetzen. Da die Verbindungen der Formeln I und II stabile und gut abspaltbare Abgangsgruppen enthalten, resultiert ein geringerer Einbau an Kohlenstoff, was für die Qualität der Endprodukte große Vorteile hat.

Die abgeschiedenen Filme können sowohl aus dem reinen IIIB-Element, als auch aus Kombination mit Elementen der V. Gruppe oder auch anderen Elementen je nach Verfahrensvariante auf beliebigen Substraten gebildet werden. Sie können je nach Substrat und Abscheidetechnik epitaktischer Natur sein.

Die Verbindungen der Formel I weisen einen für die MOCVD-Technik geeigneten Dampfdruck auf und sind daher hervorragend als Ausgangsprodukte geeignet.

Die Formel I beinhaltet zwei verschiedene Gruppen von Verbindungen der Formeln Ia (für l = 1) und Ib (für l = 2).

Die Unterformel Ia 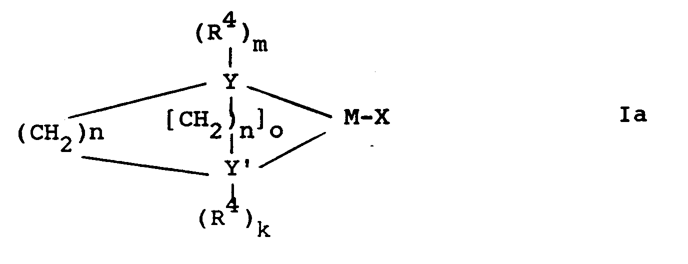 worin R⁴, m, n, Y, Y', o, k, M und X die angegebene Bedeutung haben, umfaßt solche Verbindungen, in denen das Akzeptoratom M mit zwei Donoratomen über kovalente Bindungen verbunden ist. A in Formel I ist also hier in Formel Ia bei l = 1 eine kovalente Bindung.

Dagegen umfaßt die Unterformel Ib 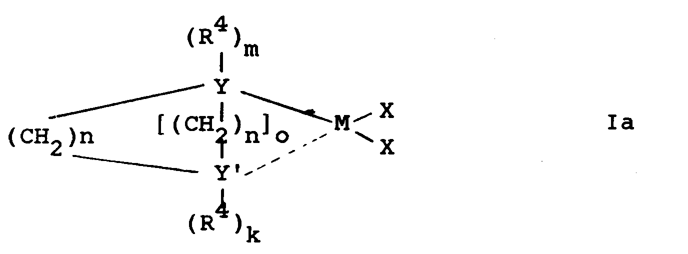 worin Y', M, Y, R⁴, m, n, o, k und X die angegebene Bedeutung haben, Verbindungen, in denen l = 2, also zwei Gruppen X am Metallatom sitzen, und daher zwischen Y' und M eine Donor-Akzeptor-Wechselwirkung erfolgt und nur ein Donoratom Y kovalent gebunden ist. Aber auch hier bildet sich eine cyclische Anordnung aus, die ein Akzeptoratom und zwei Donoratome enthält. A in Formel Ib entspricht also einer Donor-Akzeptor-Wechselwirkung zwischen Y' und M.

In Formeln I, Ia und Ib bedeutet M Aluminium (Al), Gallium (Ga) oder Indium (In), vorzugsweise Ga oder In.

Y und Y' in diesen Formeln können gleich oder verschieden sein. Vorzugsweise haben sie die gleiche Bedeutung und bedeuten Stickstoff, Phosphor oder Arsen, vorzugsweise Stickstoff.

Wenn l 2 ist, können die beiden X-Reste ebenfalls gleich oder verschieden sein.

Die Reste R¹, R², R³ und R⁴ in den Formeln I, Ia und Ib bedeuten vorzugsweise jeweils eine geradkettige oder verzweigte Alkylgruppe mit 1-8 C-Atomen, vorzugsweise mit 1-5 C-Atomen. Die Alkylgruppen sind vorzugsweise geradkettig und bedeuten demnach bevorzugt Methyl, Ethyl, Propyl, Butyl, Pentyl, ferner auch Hexyl, Heptyl, Octyl, iso-Propyl, sek.-Butyl, tert.-Butyl, 2-Methylpentyl, 3-Methylpentyl oder 2-Octyl. Die Alkylreste können teilweise oder auch vollständig fluoriert sein und z.B. Monofluormethyl, Trifluormethyl, Difluorethyl, Trifluorethyl, Pentafluorethyl, Hexafluorisopropyl oder Trifluorpropyl bedeuten.

Falls R¹, R², R³ und/oder R⁴ eine Cycloalkyl- oder Cycloalkenylgruppe mit 3-8 C-Atomen bedeuten, so bedeuten sie vorzugsweise Cyclopropyl, Cyclobutyl, Cyclopentyl, Cyclopentenyl, Cyclohexyl, Cyclohexenyl, Cyclohexadienyl, Cycloheptyl, Cycloheptenyl, Cycloheptadienyl, Cyclooctyl, Cyclooctenyl, Cyclooctadienyl, Cyclooctatrienyl oder Cyclooctatetraenyl.

Vorzugsweise stellen R¹, R², R³ und/oder R⁴ auch Alkenylgruppen mit 3-8 C-Atomen, vorzugsweise mit 3-5 C-Atomen dar. Sie bedeuten demnach vorzugsweise Propenyl, Butenyl, Pentenyl ferner Hexenyl, Heptenyl oder Octenyl.

Weiterhin sind Verbindungen der vorstehenden Formeln bevorzugt, worin R¹ , R² , R³ und/oder R⁴ eine Arylgruppe bedeuten. Dabei ist vorzugsweise Aryl gleichbedeutend mit einer Phenylgruppe. Diese Phenylgruppe kann auch substituiert vorliegen. Da diese Substituenten keinen wesentlichen Einfluß auf den angestrebten Verwendungszweck ausüben, sind alle Substituenten erlaubt, die keinen störenden Einfluß auf die Zersetzungsreaktion haben.

Die beiden Reste R⁴ in den Formel I, Ia und Ib können gleiche oder unterschiedliche Bedeutungen haben.

n bedeutet 2, 3 oder 4, vorzugsweise 2 oder 3. m und o bedeuten jeweils 0 oder 1, wobei m + o 1 ist.

Falls M Aluminium, l = 1 und X R³ bedeutet, dann ist R³ vorzugsweise eine Alkyl- oder Alkenylgruppe mit 3-8 C-Atomen, wobei diese Gruppen teilweise oder vollständig fluoriert sein können, eine Cycloalkyl- oder Cycloalkenylgruppe mit 3-8 C-Atomen oder eine Arylgruppe, wobei für alle diese Gruppen die bereits angegebenen bevorzugten Bedeutungen gelten.

X in den Formeln I, Ia und Ib bedeutet vorzugsweise R³, mit den dafür angegebenen bevorzugten Bedeutungen, oder -(CHR⁵)ₚ-Z. p bedeutet vorzugsweise 2, 3 oder 4. Falls Z Fluor oder eine Perfluoralkylgruppe bedeutet, kann p auch 0 sein.

R⁵ stellt entweder ein H-Atom oder eine Alkylgruppe mit bis zu 4 C-Atomen dar, die teilweise oder vollständig fluoriert sein kann. R⁵ bedeutet demnach vorzugsweise H, Methyl, Ethyl, Propyl, Butyl, Trifluormethyl, Pentafluorethyl, Monofluor- oder Difluormethyl.

Vorzugsweise bedeutet bei p > 1 nur einer der R⁵-Reste eine Alkylgruppe mit den angegebenen bevorzugten Bedeutungen. Die anderen anwesenden R⁵-Reste bedeuten dann vorzugsweise H.

X bedeutet ferner bevorzugt o-(CH₂)ᵣ-C₆H₄-(CH₂)ₛ-Z, 1,2-(CH₂)ᵣ-C₆H₁₀-(CH₂)ₛ-Z, 1,2-(CH₂)ᵣ-C₅H₈-(CH₂)ₛ-Z oder auch 1,2-(CH₂)ᵣ-C₄H₆-(CH₂)ₛ-Z, worin r und s jeweils 0, 1 oder 2 bedeuten.

Z bedeutet in erster Linie bevorzugt -NR¹R², F oder Perfluoralkyl mit vorzugsweise bis zu 4 C-Atomen, und demnach bevorzugt Trifluormethyl, Pentafluorethyl, Heptafluorpropyl, Hexafluorisopropyl oder Nonafluorbutyl. In zweiter Linie bevorzugt ist Z -PR¹R² oder -AsR¹R².
Die erfindungsgemäßen Verbindungen können daher auch 3 oder 4 Donoratome im Molekül enthalten.
R¹ und R² haben dabei die angegebenen bevorzugten Bedeutungen.

Demnach sind folgende Gruppierungen (1)-(17) für X besonders bevorzugt:

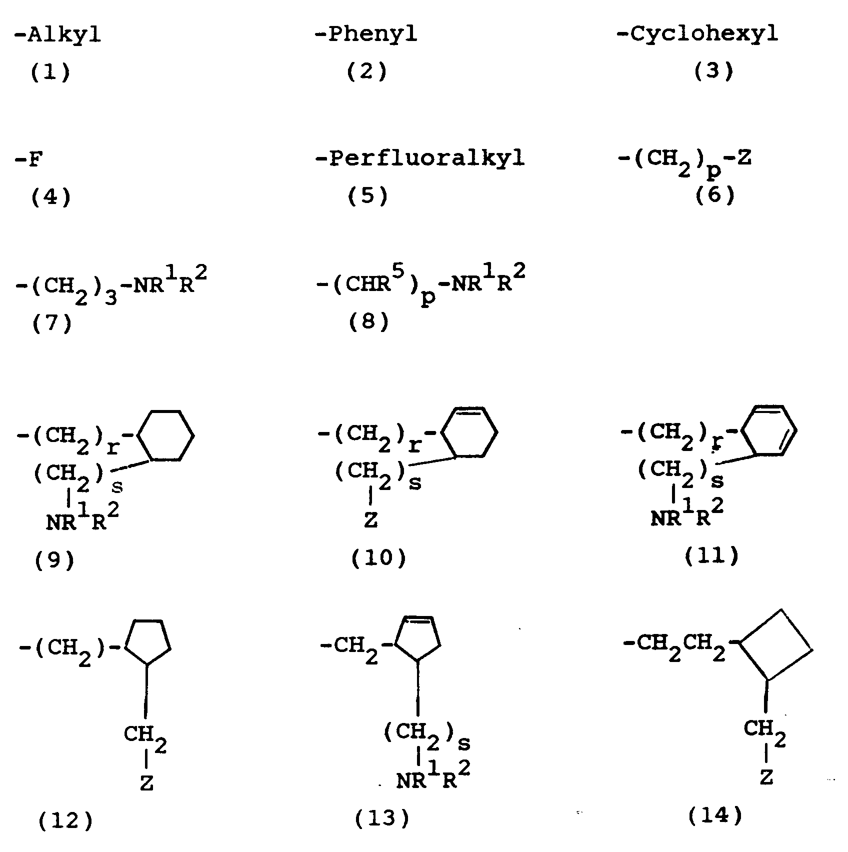

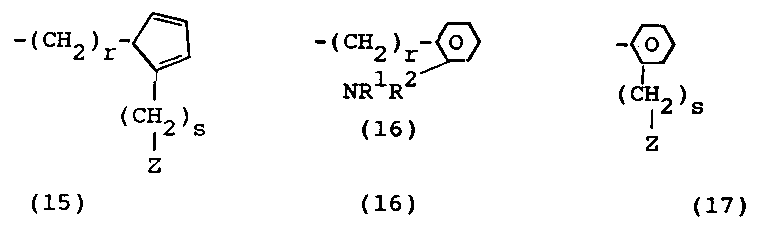

Immer wenn X die Gruppe Z enthält, erfolgt eine weitere intramolekulare Stabilisierung durch Elektronenübertragung vom Stickstoff, Phosphor, Fluor oder Arsen auf das Element M.

Formel Ia umfaßt beispielsweise folgende Unterformeln Iae-Iaf, die besonders bevorzugt sind.

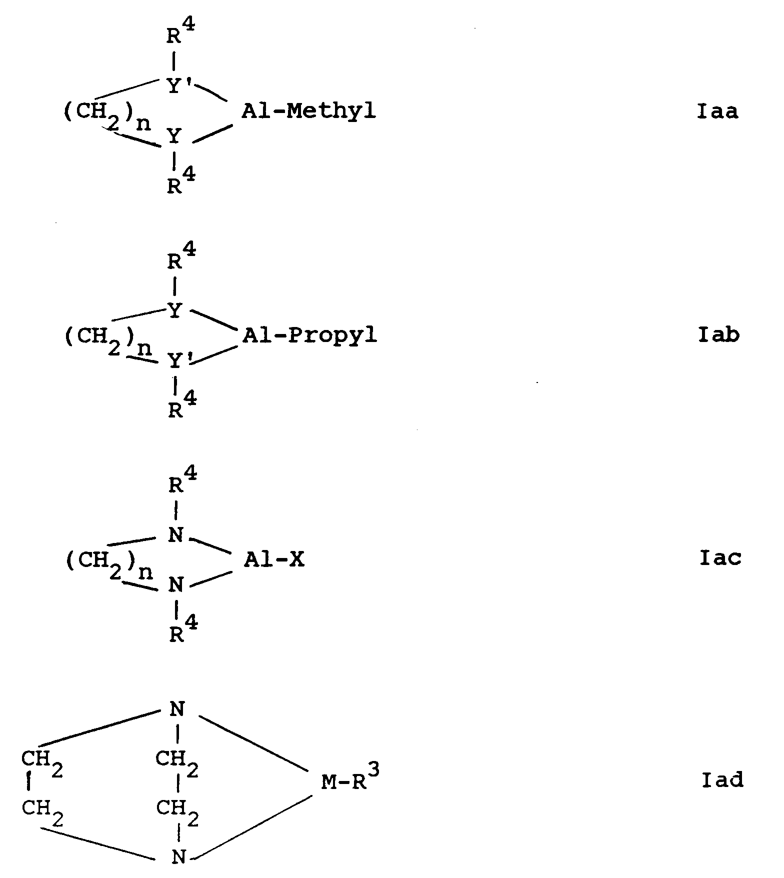

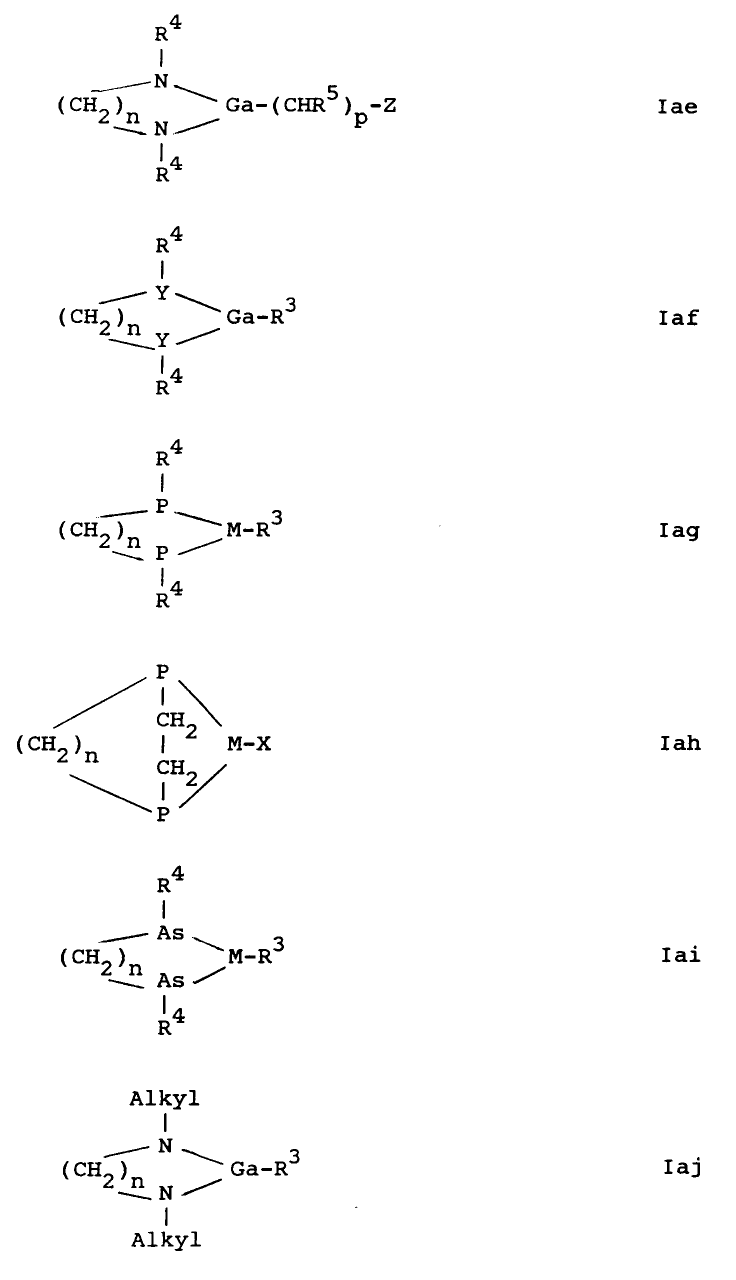

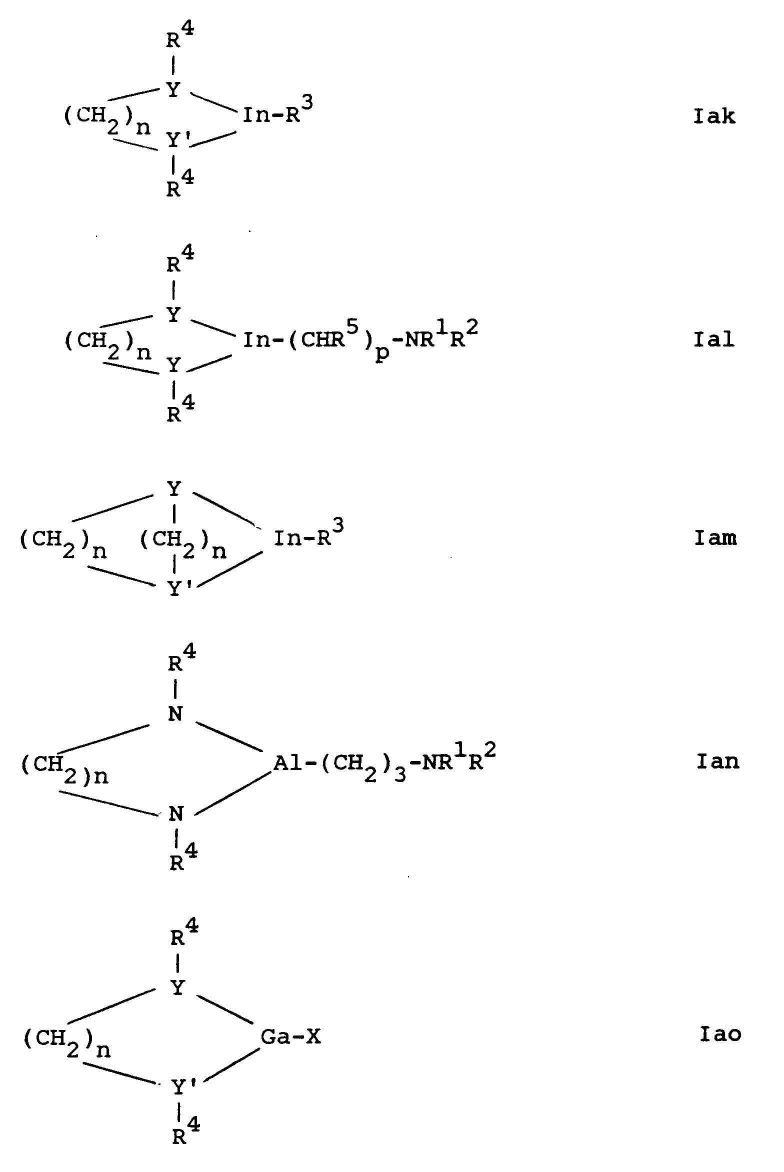

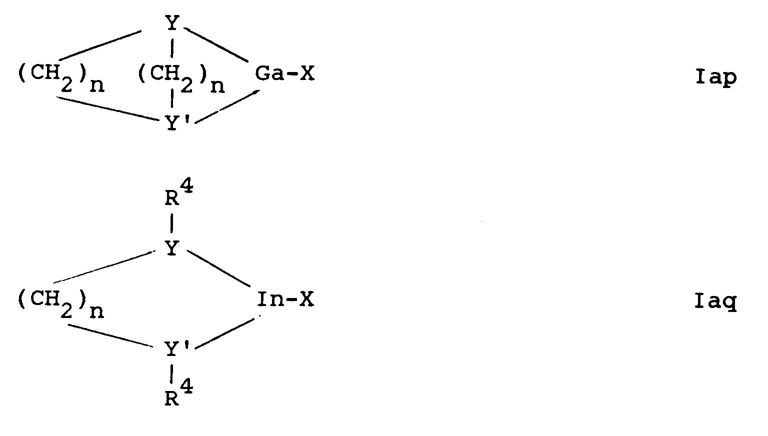

Folgende Gruppe von Formeln Iba-Ibl sind besonders bevorzugte Vertreter der Formel Ib:

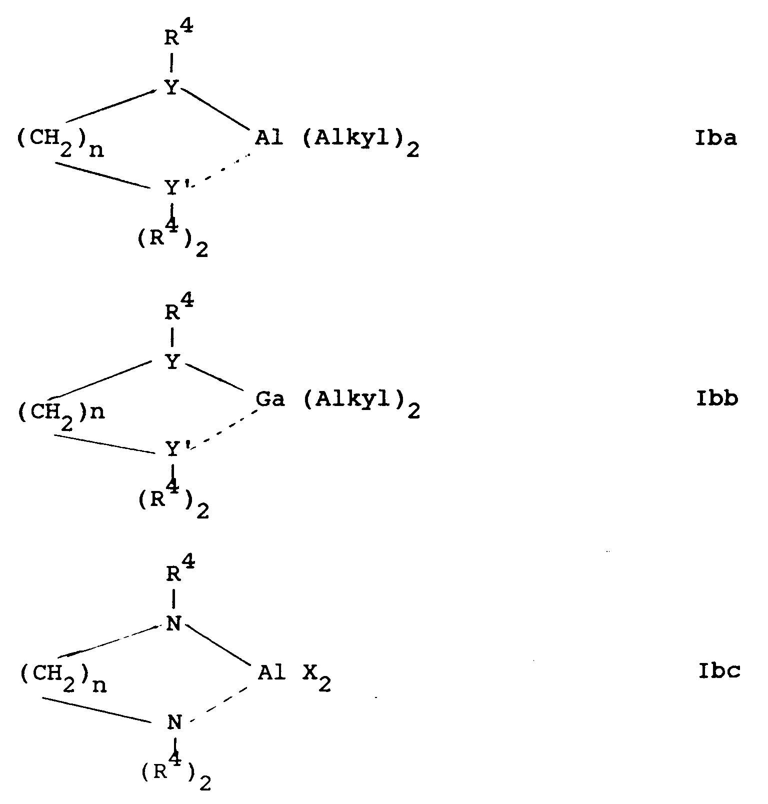

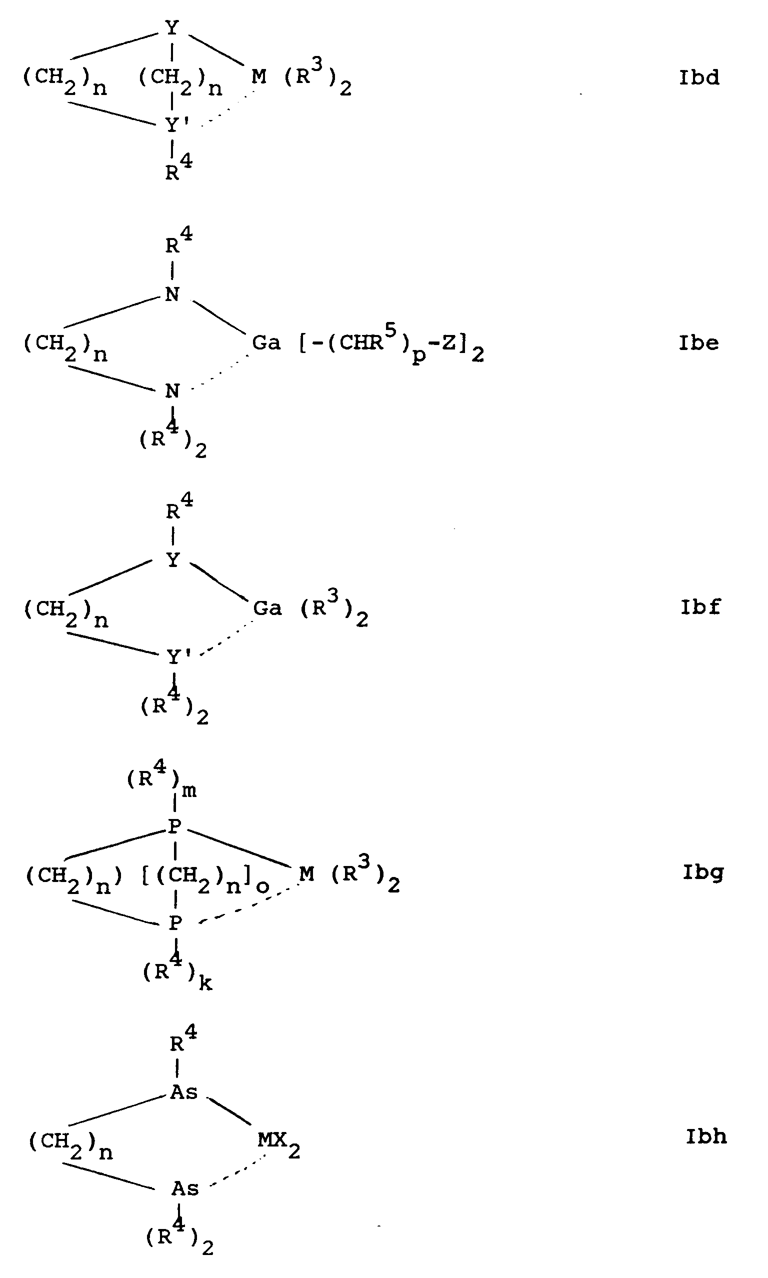

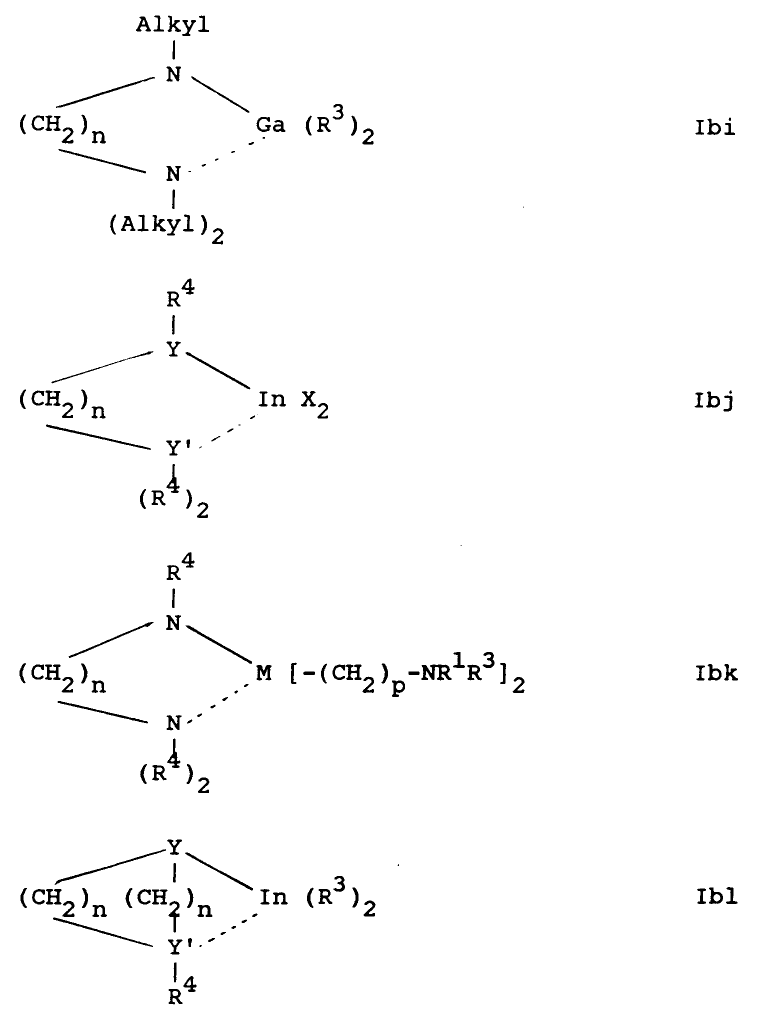

Die Verbindungen der Formel I sind hervorragend für die MOCVD-Epitaxie bzw. MOCVD-Methode geeignet, da sie sich bei höheren Temperaturen unter Freisetzung des entsprechenden Metalles zersetzen. Sie sind ebenfalls für die anderen Methoden der Gasphasenabscheidung wie Photo-MOVP, Laser-CVD oder MOMS geeignet.

Die Verbindungen der Formel I werden nach an sich bekannten Methoden hergestellt, wie sie in der Literatur (z.B. G. Bähr, P. Burba, Methoden der organischen Chemie, Band XIII/4, Georg Thieme Verlag, Stuttgart (1970)) beschrieben sind und zwar unter Reaktionsbedingungen, die für die genannten Umsetzungen bekannt und geeignet sind. Dabei kann man auch von an sich bekannten, hier nicht näher erwähnten Varianten Gebrauch machen.

So können Verbindungen der Formel I allgemein dadurch hergestellt werden, daß man das entsprechende Metallhalogenid-Derivat mit einem Alkalimetallorganyl der gewünschten Lewis-Base oder einer Grignard-Verbindungen in einem inerten Lösungsmittel umsetzt.

Die Umsetzungen erfolgen vorzugsweise in inerten Lösungsmitteln. Als Lösungsmittel kommen dabei alle diejenigen in Frage, die die Umsetzung nicht stören und nicht in das Reaktionsgeschehen eingreifen. Die Reaktionsbedingungen entsprechen im wesentlichen denen, die aus der Literatur für die Herstellung ähnlicher Verbindungen bekannt sind.

Beim erfindungsgemäßen Verfahren zur Herstellung dünner Filme oder epitaktischer Schichten auf beliebigen Substraten setzt man bei den an sich bekannten Gasphasenabscheidungs-Prozessen von metallorganischen Verbindungen als Ausgangsverbindungen die stabilisierten metallorganischen Adduktverbindungen der Formel I ein. Die Reaktionsbedingungen können analog den aus der Literatur bekannten und dem Fachmann geläufigen Werten gewählt werden.

Zur Herstellung von Verbindungshalbleitern, elektrischen, dielektrischen, elektronischen, optischen und optoelektronischen Systemen können beim erfindungsgemäßen Verfahren während des Abscheidungsprozesses in der Zersetzungskammer eine oder mehrere unter den angewandten Reaktionsbedingungen gasförmige Verbindungen des Arsens, Antimons oder Phosphors, beispielsweise AsH₃, As(CH₃)₃, PH₃ oder SbH₃, zusätzlich zugesetzt werden. Eine weitere Variante des erfindungsgemäßen Verfahrens besteht darin, daß man während des Abscheidungsprozesses zusätzlich zu den erfindungsgemäßen metallorganischen Addukten der Formel I Dotierstoffe zusetzt. Als Dotierstoffe werden dabei flüchtige metallorganische Verbindungen von Eisen, Magnesium, Zink oder Chrom eingesetzt. Als bevorzugte Verbindungen gelten dabei z.B. Zn(CH₃)₂, Mg(CH₃)₂ oder Fe(C₅H₅)₂.

Ferner ist es möglich, die Verbindungen der Formel I als Dotierstoffe während des Abscheidungsprozesses anderer metallorganischer Verbindungen zuzusetzen.

Die nach den erfindungsgemäßen Verfahren hergestellten Schichten können verwendet werden für die Herstellung von elektrischen, dielektrischen, elektronischen, optischen und optoelektronischen Bau- und Schaltelementen, Verbindungshalbleitern oder Lasern.

Da bei den momentan im Einsatz befindlichen Epitaxie-anlagen aus thermodynamischen Gründen nur ca. 1-10 % der eingesetzten freien Metallalkyle als Epitaxieschicht auf dem Substrat abgeschieden werden kann, stellt die Vernichtung der überschüssigen Metallalkyle, die aufgrund ihrer extremen Empfindlichkeit nicht zurückgewonnen werden können, ein erhebliches Problem dar. Die erfindungsgemäßen Verbindungen der Formel I eröffenen dagegen aufgrund ihrer hohen Stabilität neue Möglichkeiten zur gefahrlosen Vernichtung oder zur Rückgewinnung der wertvollen III B-Verbindungen.

Die folgenden Beispiele sollen die Erfindung näher erläutern, ohne sie zu begrenzen. Temperaturangaben erfolgen in Grad Celsius oder Kelvin. Fp. bedeutet Schmelzpunkt und Kp. Siedepunkt.

### Beispiel 1

14,6 g (0,15 mol) Dilithium-N,N'-dimethylethylendiamid in 300 ml n-Hexan werden mit 25,5 g (0,15 mol) Ethylgalliumdichlorid in 100 ml n-Hexan bei -20° versetzt. Man rührt 2 Stunden bei Raumtemperatur, filtriert ab und engt das Filtrat ein. Nach Sublimation bei einer Badtemperatur von 220° und einem Vakuum von 10⁻¹ mbar erhält man 2,5-Dimethyl-1-ethyl-2,5-diaza-1-galla-cyclopentan als farblosen, luftstabilen Feststoff.

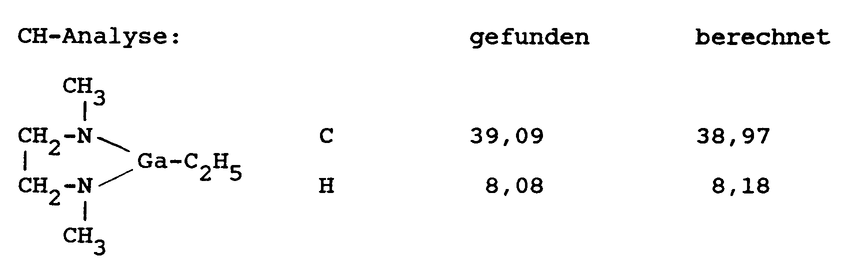

Analog werden hergestellt:
2,5-Dimethyl-1-methyl-2,5-diaza-1-galla-cyclopentan
2,5-Dimethyl-1-propyl-2,5-diaza-1-galla-cyclopentan
2,5-Diethyl-1-ethyl-2,5-diaza-1-galla-cyclopentan
2,5-Diethyl-1-butyl-2,5-diaza-1-galla-cyclopentan
2,5-Diethyl-1-methyl-2,5-diaza-1-galla-cyclohexan
2,5-Dimethyl-1-ethyl-2,5-diaza-1-galla-cyclohexan
2,5-Dimethyl-1-ethyl-2,5-diaza-1-inda-cyclohexan
2,5-Dimethyl-1-ethyl-2,5-diaza-1-inda-cyclopentan
2,5-Diethyl-1-ethyl-2,5-diaza-1-inda-cyclohexan
2,5-Diethyl-1-ethyl-2,5-diaza-1-inda-cyclopentan
2,5-Dimethyl-1-propyl-2,5-diaza-1-inda-cyclohexan
2,5-Dipropyl-1-methyl-2,5-diaza-1-inda-cyclohexan
2,5-Dimethyl-1-phenyl-2,5-diaza-1-galla-cyclohexan
2,5-Dimethyl-1-methyl-2,5-diaza-1-alumina-cyclohexan
2,5-Dimethyl-1-methyl-2,5-diaza-1-alumina-cyclopentan
2,5-Diethyl-1-pentyl-2,5-diaza-1-alumina-cyclopentan
2,5-Diethyl-1-pentyl-2,5-diaza-1-alumina-cyclohexan
2,5-Diphenyl-1-methyl-2,5-diaza-1-galla-cyclohexan
2-Ethyl-5-methyl-1-ethyl-2,5-diaza-1-galla-cyclohexan
2,5-Dimethyl-1-ethyl-2,5-diaza-1-inda-cycloheptan
2,5-Diethyl-1-methyl-2,5-diaza-1-galla-cycloheptan

### Beispiel 2

Zu 7,4 g (0,075 mol) Dilithium-N,N'-dimethylethylendiamid in 150 ml THF gibt man bei -20 °C 16,8 g (0,075 mol) 3-Dimethylaminopropylgalliumdichlorid (erhältlich durch Umsetzung von 3-Dimethylaminopropyl-1-Magnesiumchlorid mit Galliumtrichlorid) in 75 ml THF.

Man rührt 1 Stunde nach, läßt über Nacht bei Raumtemperatur stehen, engt auf die Hälfte ein, gibt 100 ml n-Hexan zu, filtriert ab und entfernt das Lösungsmittel im Vakuum. Nach Sublimation im Vakuum (10⁻¹ mbar) und bei einer Badtemperatur von 220 °C erhält man 2,5-Dimethyl-1-(3-dimethylaminopropyl)-2,5-diaza-1-galla-cyclopentan.

Analog werden hergestellt:
2,5-Dimethyl-1-(3-dimethylaminopropyl)-2,5-diaza-1-galla-cyclohexan
2,5-Dimethyl-1-(3-dimethylaminopropyl)-2,5-diaza-1-galla-cycloheptan
2,5-Dimethyl-1-(3-diethylaminopropyl)-2,5-diaza-1-galla-cyclopentan
2,5-Dimethyl-1-(3-diethylaminopropyl)-2,5-diaza-1-galla-cyclohexan
2,5-Dimethyl-1-(3-diethylaminopropyl)-2,5-diaza-1-galla-cycloheptan
2,5-Diethyl-1-(3-dimethylaminopropyl)-2,5-diaza-1-galla-cyclohexan
2,5-Diethyl-1-(3-dimethylaminopropyl)-2,5-diaza-1-galla-cyclopentan
2,5-Diethyl-1-(3-dimethylaminopropyl)-2,5-diaza-1-galla-cycloheptan
2,5-Diethyl-1-(4-dimethylaminobutyl)-2,5-diaza-1-galla-cyclohexan
2,5-Diethyl-1-(4-dimethylaminobutyl)-2,5-diaza-1-galla-cyclopentan
2,5-Diethyl-1-(4-dimethylaminobutyl)-2,5-diaza-1-galla-cycloheptan
2-Ethyl-5-propyl-1-(4-dimethylaminobutyl)-2,5-diaza-1-galla-cyclohexan
2-Ethyl-5-propyl-1-(4-dimethylaminobutyl)-2,5-diaza-1-galla-cyclopentan
2-Ethyl-5-propyl-1-(4-dimethylaminobutyl)-2,5-diaza-1-galla-cycloheptan
2,5-Dimethyl-1-(3-diphenylaminopropyl)-2,5-diaza-1-galla-cyclohexan
2,5-Dimethyl-1-(3-diphenylaminopropyl)-2,5-diaza-1-galla-cyclopentan
2,5-Dimethyl-1-(3-diphenylaminopropyl)-2,5-diaza-1-galla-cycloheptan

2,5-Dimethyl-1-(3-dimethylaminopropyl)-2,5-diaza-1-alumina-cyclopentan
2,5-Dimethyl-1-(3-dimethylaminopropyl)-2,5-diaza-1-alumina-cyclohexan
2,5-Dimethyl-1-(3-dimethylaminopropyl)-2,5-diaza-1-alumina-cycloheptan
2,5-Dimethyl-1-(3-diethylaminopropyl)-2,5-diaza-1-alumina-cyclopentan
2,5-Dimethyl-1-(3-diethylaminopropyl)-2,5-diaza-1-alumina-cyclohexan
2,5-Dimethyl-1-(3-diethylaminopropyl)-2,5-diaza-1-alumina-cycloheptan
2,5-Diethyl-1-(3-dimethylaminopropyl)-2,5-diaza-1-alumina-cyclohexan
2,5-Diethyl-1-(3-dimethylaminopropyl)-2,5-diaza-1-alumina-cyclopentan
2,5-Diethyl-1-(3-dimethylaminopropyl)-2,5-diaza-1-alumina-cycloheptan
2,5-Diethyl-1-(4-dimethylaminobutyl)-2,5-diaza-1-alumina-cyclohexan
2,5-Diethyl-1-(4-dimethylaminobutyl)-2,5-diaza-1-alumina-cyclopentan
2,5-Diethyl-1-(4-dimethylaminobutyl)-2,5-diaza-1-alumina-cycloheptan
2-Ethyl-5-propyl-1-(4-dimethylaminobutyl)-2,5-diaza-1-alumina-cyclohexan
2-Ethyl-5-propyl-1-(4-dimethylaminobutyl)-2,5-diaza-1-alumina-cyclopentan
2-Ethyl-5-propyl-1-(4-dimethylaminobutyl)-2,5-diaza-1-alumina-cycloheptan
2,5-dimethyl-1-(3-diphenylaminopropyl)-2,5-diaza-1-alumina-cyclohexan
2,5-Dimethyl-1-(3-diphenylaminopropyl)-2,5-diaza-1-alumina-cyclopentan
2,5-Dimethyl-1-(3-diphenylaminopropyl)-2,5-diaza-1-alumina-cycloheptan

2,5-Dimethyl-1-(3-dimethylaminopropyl)-2,5-diaza-1-inda-cyclopentan
2,5-Dimethyl-1-(3-dimethylaminopropyl)-2,5-diaza-1-inda-cyclohexan
2,5-Dimethyl-1-(3-dimethylaminopropyl)-2,5-diaza-1-inda-cycloheptan
2,5-Dimethyl-1-(3-diethylaminopropyl)-2,5-diaza-1-inda-cyclopentan
2,5-Dimethyl-1-(3-diethylaminopropyl)-2,5-diaza-1-inda-cyclohexan
2,5-Dimethyl-1-(3-diethylaminopropyl)-2,5-diaza-1-inda-cycloheptan
2,5-Diethyl-1-(3-dimethylaminopropyl)-2,5-diaza-1-inda-cyclohexan
2,5-Diethyl-1-(3-dimethylaminopropyl)-2,5-diaza-1-inda-cyclopentan
2,5-Diethyl-1-(3-dimethylaminopropyl)-2,5-diaza-1-inda-cycloheptan
2,5-Diethyl-1-(4-dimethylaminobutyl)-2,5-diaza-1-inda-cyclohexan
2,5-Diethyl-1-(4-dimethylaminobutyl)-2,5-diaza-1-inda-cyclopentan
2,5-Diethyl-1-(4-dimethylaminobutyl)-2,5-diaza-1-inda-cycloheptan
2-Ethyl-5-propyl-1-(4-dimethylaminobutyl)-2,5-diaza-1-inda-cyclohexan
2-Ethyl-5-propyl-1-(4-dimethylaminobutyl)-2,5-diaza-1-inda-cyclopentan
2-Ethyl-5-propyl-1-(4-dimethylaminobutyl)-2,5-diaza-1-inda-cycloheptan
2,5-Dimethyl-1-(3-diphenylaminopropyl)-2,5-diaza-1-inda-cyclohexan
2,5-Dimethyl-1-(3-diphenylaminopropyl)-2,5-diaza-1-inda-cyclopentan
2,5-Dimethyl-1-(3-diphenylaminopropyl)-2,5-diaza-1-inda-cycloheptan.

### Beispiel 3

Bei Raumtemperatur gibt man langsam 14 g Diethylgalliumchlorid in 60 ml n-Hexan unter Argonatmosphäre zu 9,7 g Lithium-N,N,N'-trimethylethylenamid in 100 ml n-Hexan. Man filtriert nach beendeter Reaktion das LiCl ab, wäscht dreimal mit n-Hexan nach und führt eine fraktionierte Destillation im Vakuum durch. Nach Anziehen des Lösungsmittels destilliert Diethylgallium(2-dimethylaminoethylmethylamid) bei 126 °C/0,4 mbar über.

Analog werden hergestellt:
Dimethylgallium(2-dimethylaminoethylmethylamid)
Dimethylgallium(2-diethylaminoethylmethylamid)
Diethylgallium(2-diethylaminoethylmethylamid)
Diethylgallium(2-dimethylaminoethylethylamid)
Dipropylgallium(2-dimethylaminoethylmethylamid)
Dimethylgallium(3-dimethylaminopropylmethylamid)

Diethylaluminium(2-diethylaminoethylmethylamid)
Diethylaluminium(2-dimethylaminoethylpropylamid)

Diphenylaluminium(2-diethylaminoethylmethylamid)
Methyl(3-dimethylaminopropyl)aluminium(2-dimethylaminoethylmethylamid)
Bis-(3-dimethylaminopropyl)-gallium(3-dimethylaminopropylmethylamid)
Dimethylindium(2-dimethylaminoethylmethylamid)
Diethylindium(3-diethylaminopropylmethylamid)
Diphenylindium(2-diethylaminoethylmethylamid)
Dipropylindium(2-dimethylaminoethylethylamid).

## Patentansprüche

1. Verwendung heterocyclischer, metallorganischer Verbindungen der Formel I 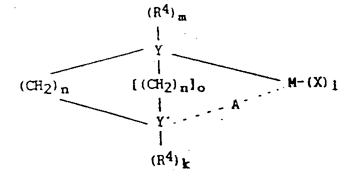 worin
M Aluminium, Gallium oder Indium,
Y, Y' jeweils Stickstoff, Phosphor oder Arsen,
n jeweils 2, 3 oder 4,
m 0 oder 1,
o 0 oder 1,
m + o 1,
1 1 oder 2,
A falls 1 = 1 eine kovalente Bindung zwischen Y' und M, oder falls 1 = 2 eine Donor-Akzeptor-Wechselwirkung zwischen Y' und M,
k 0,1 oder 2 mit den Maßgaben, daß
im Falle 1 = 1 und 0 = 1 k = 0
im Falle 1 = 2 und o = 1 k = 1
im Falle 1 = 1 und o = 0 k = 1 und
im Falle 1 = 2 und 0 = 0 k = 2,
X R³,
-(CHR⁵)p-Z mit p = 1, 2, 3, 4 oder 5,
im Falle von Z = F oder Perfluoralkyl kann p auch O sein,
o-(CH₂)ᵣ-C₆H₄-(CH₂)ₛ-Z,
1,2-(CH₂)ᵣ-C₆H₁₀-(CH₂)ₛ-Z,
1,2-(CH₂)ᵣ-C₆H₈-(CH₂)ₛ-Z,
1,2-(CH₂)ᵣ-C₆H₆-(CH₂)ₛ-Z,
1,2-(CH₂)ᵣ-C₅H₈-(CH₂)ₛ-Z,
1,2-(CH₂)ᵣ-C₅H₆-(CH₂)ₛ-Z,
1,2(CH₂)ᵣ-C₅H₄-(CH₂)ₛ-Z oder
1,2-(CH₂)ᵣ-C₄H₆-(CH₂)ₛ-Z,
Z -NR¹R², -PR¹R², -AsR¹R², -F oder Perfluoralkyl mit bis zu 7 C-Atomen,
r und s jeweils unabhängig voneinander 0, 1, 2 oder 3,
R¹, R², R³ und R⁴ jeweils unabhängig voneinander H, eine Alkyl- oder Alkenylgruppe mit bis zu 8 C-Atomen, wobei diese Gruppen teilweise oder vollständig fluoriert sein können, eine Cycloalkyl- oder Cycloalkenylgruppe mit 3-8 C-Atomen oder eine Arylgruppe,
und
R⁵ jeweils H oder eine Alkylgruppe mit bis zu 4 C-Atomen, die auch teilweise oder vollständig fluoriert sein kann,
bedeutet, zur Gasphasenabscheidung von Schichten auf Substraten.

2. Verwendung der Verbindungen der Formel I nach Anspruch 1 zur Abscheidung epitaktischer Schichten.

3. Verfahren zur Herstellung dünner Filme auf Substraten durch Gasphasenabscheidung aus metallorganischen Verbindungen, dadurch gekennzeichnet, daß als metallorganische Verbindungen die Verbindungen der Formel I nach Anspruch 1 eingesetzt werden.

4. Verfahren nach Anspruch 3, dadurch gekennzeichnet, daß man zur Herstellung von elektrischen, dielektrischen, elektronischen, optischen und optoelektronischen Systemen während des Abscheidungsprozesses eine oder mehrere unter den angewandten Reaktionsbedingungen gasförmige Verbindungen des Arsens, Antimons oder Phosphors zuführt.

5. Verfahren nach Anspruch 3, dadurch gekennzeichnet, daß man zusätzlich zu den metallorganischen Verbindungen der Formel I während des Abscheidungsprozesses Dotierstoffe zusetzt.

6. Verfahren nach Anspruch 3, dadurch gekennzeichnet, daß die Verbindungen der Formel I nach Anspruch 1 als Dotierstoffe während des Abscheidungsprozesses von anderen metallorganischen Verbindungen zugesetzt werden.

7. Heterocyclische, metallorganische Verbindungen der Formel I 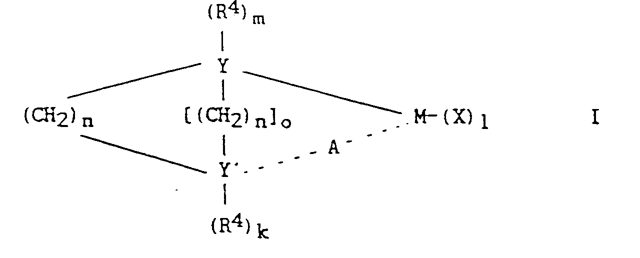 worin
M Gallium oder Indium,
Y, Y' jeweils Stickstoff, Phosphor oder Arsen,
n jeweils 2, 3 oder 4,
m 0 oder 1,
o 0 oder 1,
m + o 1,
1 1 oder 2,
A falls 1 = 1 eine kovalente Bindung zwischen Y' und M, oder falls 1 = 2 eine Donor-Akzeptor-Wechselwirkung zwischen Y' und M,
k 0,1 oder 2 mit den Maßgaben, daß
im Falle 1 = 1 und 0 = 1 k = 0
im Falle 1 = 2 und o = 1 k = 1
im Falle 1 = 1 und o = 0 k = 1 und
im Falle 1 = 2 und 0 = 0 k = 2,
X R³,
-(CHR⁵)p-Z mit p = 1, 2, 3, 4 oder 5,
im Falle von Z = F oder Perfluoralkyl kann p auch O sein,
o-(CH₂)ᵣ-C₆H₄-(CH₂)ₛ-Z,
1,2-(CH₂)ᵣ-C₆H₁₀-(CH₂)ₛ-Z,
1,2-(CH₂)ᵣ-C₆H₈-(CH₂)ₛ-Z,
1,2-(CH₂)ᵣ-C₆H₆-(CH₂)ₛ-Z,
1,2-(CH₂)ᵣ-C₅H₈-(CH₂)ₛ-Z,
1,2-(CH₂)ᵣ-C₅H₆-(CH₂)ₛ-Z,
1,2(CH₂)ᵣ-C₅H₄-(CH₂)ₛ-Z oder
1,2-(CH₂)ᵣ-C₄H₆-(CH₂)ₛ-Z,
Z -NR¹R², -PR¹R², -AsR¹R², -F oder Perfluoralkyl mit bis zu 7 C-Atomen,
r und s jeweils unabhängig voneinander 0, 1, 2 oder 3,
R¹, R², R³ und R⁴ jeweils unabhängig voneinander H, eine Alkyl- oder Alkenylgruppe mit bis zu 8 C-Atomen, wobei diese Gruppen teilweise oder vollständig fluoriert sein können, eine Cycloalkyl- oder Cycloalkenylgruppe mit 3-8 C-Atomen oder eine Arylgruppe,
und
R⁵ jeweils H oder eine Alkylgruppe mit bis zu 4 C-Atomen, die auch teilweise oder vollständig fluoriert sein kann, bedeutet.

## Claims

1. Use of heterocyclic, organometallic compounds of the formula I 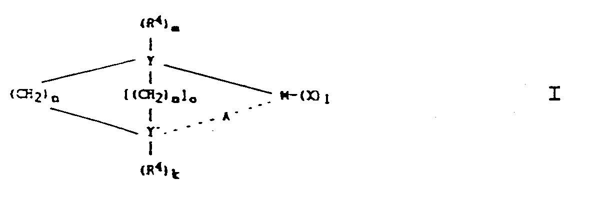 wherein
M is aluminium, gallium or indium,
Y and Y' are each nitrogen, phosphorus or arsenic,
n is in each case 2, 3 or 4,
m is 0 or 1,
o is 0 or 1,
m + o is 1,
l is 1 or 2,
A is a covalent bond between Y' and M if l = 1, or a donor-acceptor interaction between Y' and M if l = 2,
k is 0, 1 or 2, subject to the provisions that, in the event that l = 1 and o = 1, k = 0,
in the event that l = 2 and o = 1, k = 1,
in the event that l = 1 and o = 0, k = 1 and,
in the event that l = 2 and o = 0, k = 2,
X is R³,
-(CHR⁵)ₚ-Z in which p = 1, 2, 3, 4 or 5, it also being possible for p to be 0 in the event that Z = F or perfluoroalkyl,
o-(CH₂)ᵣ-C₆H₄-(CH₂)ₛ-Z,
1,2-(CH₂)ᵣ-C₆H₁₀-(CH₂)ₛ-Z,
1,2-(CH₂)ᵣ-C₆H₈-(CH₂)ₛ-Z,
1,2-(CH₂)ᵣ-C₆H₆-(CH₂)ₛ-Z,
1,2-(CH₂)ᵣ-C₅H₈-(CH₂)ₛ-Z,
1,2-(CH₂)ᵣ-C₅H₆-(CH₂)ₛ-Z,
1,2-(CH₂)ᵣ-C₅H₄-(CH₂)ₛ-Z or
1,2-(CH₂)ᵣ-C₄H₈-(CH₂)ₛ-Z,
Z is -NR¹R², -PR¹R², -AsR¹R², -F or perfluoroalkyl having up to 7 C atoms,
r and s independently of one another are each 0, 1, 2 or 3,
R¹, R², R³ and R⁴ independently of one another are each H, an alkyl or alkenyl group having up to 8 C atoms, it being possible for these groups to be partially or completely fluorinated, a cycloalkyl or cycloalkenyl group having 3-8 C atoms or an aryl group, and
R⁵ is in each case H or an alkyl group having up to 4 C atoms and which can also be partially or completely fluorinated,
for the gas phase deposition of layers on substrates.

2. Use of the compounds of the formula I according to Claim 1 for the deposition of epitaxial layers.

3. Process for the preparation of thin films on substrates by gas phase deposition from organometallic compounds, characterized in that the compounds of the formula I according to Claim 1 are employed as the organometallic compounds.

4. Process according to Claim 3, characterized in that one or more compounds of arsenic, antimony or phosphorus which are gaseous under the reaction conditions used are supplied for the production of electrical, dielectric, electronic, optical and optoelectronic systems during the deposition process.

5. Process according to Claim 3, characterized in that dopants are added during the deposition process, in addition to the organometallic compounds of the formula I.

6. Process according to Claim 3, characterized in that the compounds of the formula I according to Claim 1 are added as dopants during the deposition process of other organometallic compounds.

7. Heterocyclic, organometallic compounds of the formula I 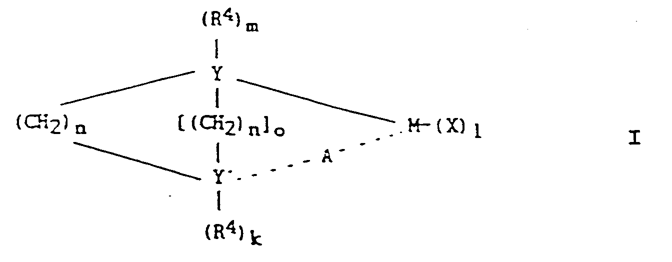 wherein
M is gallium or indium,
Y and Y' are each nitrogen, phosphorus or arsenic,
n is in each case 2, 3 or 4,
m is 0 or 1,
o is 0 or 1,
m + o is 1,
l is 1 or 2,
A is a covalent bond between Y' and M if l = 1, or a donor-acceptor interaction between Y' and M if l = 2,
k is 0, 1 or 2, subject to the provisions that, in the event that l = 1 and o = 1, k = 0,
in the event that l = 2 and o = 1, k = 1,
in the event that l = 1 and o = 0, k = 1 and,
in the event that l = 2 and o = 0, k = 2,
X is R³,
-(CHR⁵)ₚ-Z in which p = 1, 2, 3, 4 or 5, it also being possible for p to be 0 in the event that Z = F or perfluoroalkyl,
o-(CH₂)ᵣ-C₆H₄-(CH₂)ₛ-Z,
1,2-(CH₂)ᵣ-C₆H₁₀-(CH₂)ₛ-Z,
1,2-(CH₂)ᵣ-C₆H₈-(CH₂)ₛ-Z,
1,2-(CH₂)ᵣ-C₆H₆-(CH₂)ₛ-Z,
1,2-(CH₂)ᵣ-C₅H₈-(CH₂)ₛ-Z,
1,2-(CH₂)ᵣ-C₅H₆-(CH₂)ₛ-Z,
1,2-(CH₂)ᵣ-C₅H₄-(CH₂)ₛ-Z or
1,2-(CH₂)ᵣ-C₄H₆-(CH₂)ₛ-Z,
Z is -NR¹R², -PR¹R², -AsR¹R², -F or perfluoroalkyl having up to 7 C atoms,
r and s independently of one another are each 0, 1, 2 or 3,
R¹, R², R³ and R⁴ independently of one another are each H, an alkyl or alkenyl group having up to 8 C atoms, it being possible for these groups to be partially or completely fluorinated, a cycloalkyl or cycloalkenyl group having 3-8 C atoms or an aryl group, and
R⁵ is in each case H or an alkyl group having up to 4 C atoms and which can also be partially or completely fluorinated.

## Revendications

1. Utilisation de composés organo-métalliques hétérocycliques de formule I 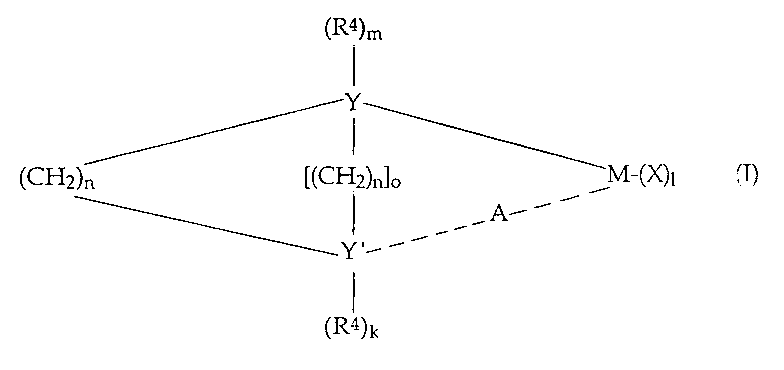 dans laquelle
M est l'aluminium, le gallium ou l'indium,
Y, Y' représentent à chaque fois l'azote, le phosphore ou l'arsenic,
n vaut à chaque fois 2, 3 ou 4,
m vaut 0 ou 1,
o vaut 0 ou 1,
m + o = 1
*l* vaut 1 ou 2,
A si *l* = 1 est une liaison de covalence entre Y' et M, ou si *l* = 2 une interaction donneur-accepteur entre Y' et M,
k vaut 0, 1 ou 2 sous réserve que
dans le cas où *l* = 1 et o = 1 k = 0
dans le cas où *l* = 2 et o = 1 k = 1
dans le cas où *l* = 1 et o = 0 k = 1 et
dans le cas où *l* = 2 et o = 0 k = 2,
X représente R³,
-(CHR⁵)p-Z avec p = 1, 2, 3, 4 ou 5,
dans le cas où Z = F ou un perfluoroalkyle, p peut également valoir 0,
O-(CH₂)ᵣ-C₆H₄-(CH₂)ₛ-Z,
1,2-(CH₂)ᵣ-C₆H₁₀-(CH₂)ₛ-Z,
1,2-(CH₂)ᵣ-C₆H₈-(CH₂)ₛ-Z,
1,2-(CH₂)ᵣ-C₆H₆-(CH₂)ₛ-Z,
1,2-(CH₂)ᵣ-C₅H₈-(CH₂)ₛ-Z,
1,2-(CH₂)ᵣ-C₅H₆-(CH₂)ₛ-Z,
1,2-(CH₂)ᵣ-C₅H₄-(CH₂)ₛ-Z ou
1,2-(CH₂)ᵣ-C₄H₆-(CH₂)ₛ-Z,
Z est -NR¹R², -PR¹R², -AsR¹R², -F ou un perfluoroalkyle ayant jusqu'à 7 atomes de carbone,
r et s valent indépendamment l'un de l'autre 0, 1, 2 ou 3,
R¹, R², R³ et R⁴ représentent chacun indépendamment l'un de l'autre H, un groupe alkyle ou alcényle ayant jusqu'à 8 atomes de carbone, ces groupes pouvant être partiellement ou entièrement fluorés, un groupe cycloalkyle ou cycloalcényle en C₃ à C₈ ou un groupe aryle,
et
R⁵ représente à chaque fois H ou un groupe alkyle ayant jusqu'à 4 atomes de carbone, qui peut également être partiellement ou entièrement fluoré,
pour la séparation en phase gazeuse de couches sur des substrats.

2. Utilisation des composés de formule I selon la revendication 1 pour la séparation de couches épitactiques.

3. Procédé de préparation de pellicules minces sur des substrats par séparation en phase gazeuse à partir de composés organo-métalliques, caractérisé en ce qu'on utilise comme composés organo-métalliques les composés de formule I selon la revendication 1.

4. Procédé selon la revendication 3, caractérisé en ce que pour préparer des systèmes électriques, diélectriques, électroniques, optiques et optoélectroniques on ajoute au cours du processus de séparation un ou plusieurs composés d'arsenic, d'antimoine ou de phosphore gazeux dans les conditions réactionnelles employées.

5. Procédé selon la revendication 3, caractérisé en ce qu'on ajoute, au cours du processus de séparation, des substances dopées en plus des composés organo-métalliques de formule I.

6. Procédé selon la revendication 3, caractérisé en ce qu'on ajoute les composés de formule I selon la revendication 1 comme substances dopées au cours du procédé de séparation d'autres composés organo-métalliques.

7. Composés organo-métalliques hétérocycliques de formule I 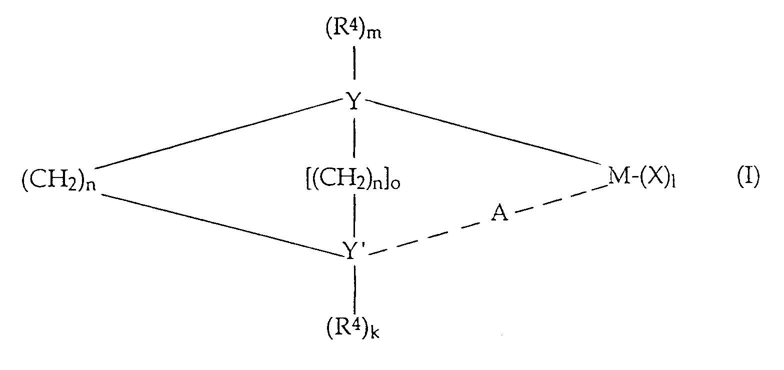 dans laquelle
M est le gallium ou l'indium,
Y, Y' est toujours l'azote, le phosphore ou l'arsenic,
n vaut à chaque fois 2, 3 ou 4,
m vaut 0 ou 1,
o vaut 0 ou 1,
m + o = 1
*l* vaut 1 ou 2,
A si *l* = 1 représente une liaison de covalence entre Y' et M, ou, si *l* = 2 , une interaction donneur-accepteur entre Y' et M,
k vaut 0, 1 ou 2, sous réserve que
dans le cas où *l* = 1 et o = 1,k = 0
dans le cas où *l* = 2 et o = 1,k = 1
dans le cas où *l* = 1 et o = 0,k = 1 et
dans le cas où *l* = 2 et o = 0,k = 2,
X représente R³,
-(CHR⁵)p-Z avec p = 1, 2, 3, 4 ou 5,
au cas où Z = F ou un perfluoroalkyle, p peut également valoir 0,
O-(CH₂)ᵣ-C₆H₄-(CH₂)ₛ-Z,
1,2-(CH₂)ᵣ-C₆H₁₀-(CH₂)ₛ-Z,
1,2-(CH₂)ᵣ-C₆H₈-(CH₂)ₛ-Z,
1,2-(CH₂)ᵣ-C₆H₆-(CH₂)ₛ-Z,
1,2-(CH₂)ᵣ-C₅H₈-(CH₂)ₛ-Z,
1,2-(CH₂)ᵣ-C₅H₆-(CH₂)ₛ-Z,
1,2-(CH₂)ᵣ-C₅H₄-(CH₂)ₛ-Z ou
1,2-(CH₂)ᵣ-C₄H₆-(CH₂)ₛ-Z,
Z représente -NR¹R², -PR¹R², -AsR¹R², -F ou un perfluoroalkyle ayant jusqu'à 7 atomes de carbone,
r et s valent chacun indépendamment l'un de l'autre 0, 1, 2 ou 3,
R¹, R², R³ et R⁴ représentent chacun indépendamment l'un de l'autre H, un groupe alkyle ou alcényle ayant jusqu'à 8 atomes de carbone, ces groupes pouvant être partiellement ou entièrement fluorés, un groupe cycloalkyle ou cycloalcényle ayant de 3 à 8 atomes de carbone ou un groupe aryle,
et
R⁵ représente toujours H ou un groupe alkyle ayant jusqu'à 4 atomes de carbone, qui peut également être partiellement ou entièrement fluoré.
